# NEUE EUROPÄISCHE PATENTSCHRIFT

(11) **EP 0 715 772 B2**
(45) Veröffentlichungstag und Bekanntmachung des Hinweises auf die Entscheidung über den Einspruch: **22.10.2003**
(45) Hinweis auf die Patenterteilung: 20.05.1998
(21) Anmeldenummer: 95921677.1
(22) Anmeldetag: 27.06.1995
(51) Int. Cl.: H01L 39/24

(54) **VERFAHREN ZUM ZIEHEN VON DRAHTFÖRMIGEN SUPRALEITERN**
PROCESS FOR DRAWING WIRE-LIKE SUPERCONDUCTORS
PROCEDE DE TREFILAGE DE SUPRACONDUCTEURS SE PRESENTANT SOUS FORME DE FILS

(30) Priorität: 30.06.1994 CH 208394; 23.06.1995 CH 184795
(43) Veröffentlichungstag der Anmeldung: 12.06.1996
(73) Patentinhaber: VOCO Draht AG, 5734 Reinach (CH)
(72) Erfinder: WACHTER, Peter, CH-8044 Zürich (CH); VOGT, Oscar, CH-5735 Pfeffikon (CH); GRAMM, Rolf, A., CH-4434 Hölstein (CH)
(74) Vertreter: Frei, Alexandra Sarah
(86) Internationale Anmeldenummer: CH9500143
(87) Internationale Veröffentlichungsnummer: WO96000984

(56) Entgegenhaltungen:
- EP-A- 0 285 319
- EP-A- 0 456 927
- WO-A-89/06053
- PATENT ABSTRACTS OF JAPAN Bd. 016, Nr. 073 (E-1169) 21 Februar 1992 & JP,A,03 263 715 (NATL RES INST FOR METALS;OTHERS: 01) 25 November 1991

## Beschreibung

Die Erfindung betrifft ein Verfahren gemäss dem Oberbegriff des ersten Patentanspruchs zum Ziehen von drahtförmigen Supraleitern, insbesondere für die Herstellung von drahtförmigen Supraleitern mit kleinem, rundem oder flachem Querschnitt.

Seit der Entdeckung der oxidischen Hochtemperatursupraleitung sind Werkstoffe bekannt, die bei Temperaturen bis zu 125°K supraleitende Eigenschaften haben. Diese Werkstoffe sind durch Sinterverfahren hergestellte, metallische Oxidkeramiken, also sehr spröde und schwer bearbeitbare Werkstoffe, die nur mit äussersten Schwierigkeiten in für technische Anwendungen notwendige Formen bringbar sind. Für viele Anwendungen in den Bereichen der Elektrotechnik und der Mikroelektronik, auch für die Herstellung von supraleitenden Magnetspulen als Energiespeicher werden draht- oder bandförmige Leiter benötigt. Diese Leiter sollten vorzugsweise herstellbar sein mit Durchmessern bis unter einen Millimeter und mit Längen bis zu mehreren Kilometern. Dabei sollten solche Leiter derart flexibel sein, dass sie schadlos um einen Radius in der Grössenordnung von 20mm biegbar sind. Des weiteren ist insbesondere im Bereiche des Magnetbaus wichtig, dass die Leiter im Magnetfeld eine möglichst hohe Stromdichte (über 10'000 A/cm²) aufweisen können.

Unter Leitung von Prof Dr. P. Wachter ist an der ETH Zürich eine Dissertation entstanden (Diss. ETH Nr. 10213, Joachim Löhle), in der derartige drahtförmige Leiter zur Hochtemperatursupraleitung beschrieben sind. Es handelt sich dabei nicht effektiv um zu einem Draht geformtes supraleitendes Material, sondern um umhülstes gesintertes, oxidisches supraleitendes Keramikmaterial, insbesondere YBa₂Cu₃Oₓ oder Bi₂Sr₂CaCu₂Oₓ. Die drahtförmigen Supraleiter werden hergestellt, indem das durch mehrfaches Pressen, Sintern und wieder Zerkleinern aus den entsprechenden Oxiden hergestellte, supraleitende Keramikmaterial in ein Rohr (Hülse) gefüllt wird und dann das gefüllte Rohr in an sich bekannter Weise in die Drahtform gezogen wird. Damit das Keramikmaterial in fertig gezogener Drahtform die gewünschten supraleitenden Eigenschaften zeigt, muss es in diesem Zustande nochmals gesintert (Endsinterung) werden und zwar unter strömendem Sauerstoff.

Drahtförmige Leiter mit flachen Querschnitten (Bänder) werden durch Walzen der noch nicht endgesinterten drahtförmigen Leiter und Endsinterung in der Bandform hergestellt. Die Bänder zeigen höhere Stromdichten als die drahtförmigen Leiter mit kreisrundem Querschnitt, was auf eine Verdichtung des Keramikmaterials und auf eine Ausrichtung der Kristallite beim Walzen zurückzuführen ist.

Für das Ziehen der drahtförmigen Leiter wird beispielsweise von einem Metallrohr mit einem Aussendurchmesser von 10mm und einem Innendurchmesser von 8mm ausgegangen in das das supraleitende Keramikmaterial gefüllt wird und das durch mehrmaliges Ziehen zu 0,5mm Aussen- und 0,4mm Innendurchmesser verformt wird, wobei bei jedem Ziehschritt eine Querschnittsverringerung von ca. 8% erreicht wird.

Nach einem analogen Verfahren werden auch drahtförmige Leiter und Bänder hergestellt mit mehr als einem supraleitenden Kern, indem das Metallrohr nicht mit dem Keramikmaterial gefüllt wird, sondern mit beispielsweise neun bereits gezogenen drahtförmigen Leitern, welche je einen Kern umhülsen. Durch Füllen eines Rohres mit bereits mehrkernigen drahtförmigen Leitern kann die Zahl der Kerne noch erhöht werden.

Damit bei der notwendigen Endsinterung das Keramikmaterial mit dem strömenden Sauerstoff in Kontakt gebracht werden kann, muss das Hülsenmaterial eine genügende Sauerstoffpermeabilität aufweisen. Aus diesem Grunde wird vorgeschlagen, zur Herstellung der drahtförmigen Leiter beispielsweise Silberrohre oder Rohre aus mit Palladium legiertem Silber zu verwenden. Silber besitzt neben einer genügenden Permeabilität für Sauerstoff auch einen genügend hohen Schmelzpunkt, um eine brauchbare Sintertemperatur zuzulassen, und ist chemisch genügend stabil, um während dem Sinterprozess weder mit dem Sauerstoff noch mit dem Keramikmaterial zu reagieren. Beim Ziehen der drahtförmigen Leiter wird die Silberhülse kalt verformt und dadurch härter. Deshalb muss sie im Laufe des oben erwähnten, beispielsweisen Ziehvorganges zwischen Ziehschritten ein bis zweimal weichgeglüht werden.

An die Qualität der drahtförmigen Leiter müssen höchste Anforderungen gestellt werden, da Störstellen die Supraleitung sehr stark beeinflussen. Die in der Dissertation beschriebenen drahtförmigen Leiter und Bänder sind in aufwendigster Handarbeit hergestellt, mit einem Aufwand, der für technische oder gar industrielle Anwendungen überhaupt nicht vertretbar ist. Die Probleme, die sich dadurch für eine industriell mögliche Herstellung, insbesondere für eine Herstellung mit einer vertretbaren Ziehgeschwindigkeit ergeben, waren weder Aufgabe der genannten Dissertation, noch werden sie durch diese Dissertation in irgendeiner Form aufgezeigt.

Die Erfindung stellt sich aus diesem Grunde die Aufgabe, ein Verfahren aufzuzeigen, mit dem die oben beschriebenen und ähnliche drahtförmige Supraleiter industriell mit einer befriedigenden Präzision, Ziehgeschwindigkeit und Ausbeute hergestellt werden können. Diese Aufgabe wird gelöst durch das erfinderische Verfahren, wie es in den Patentansprüchen definiert ist.

Die Schwierigkeit bei der Herstellung der beschriebenen, drahtförmigen Leiter und Bänder rührt davon her, dass Silber ein relativ weiches und duktiles Material ist, das dem Ziehvorgang einen entsprechend kleinen Widerstand entgegensetzt. Zudem ist nur ein Teil des zu ziehenden Materials Silber (ca. 50% des Querschnittes). Der Kern besteht aus einem spröden, nicht feinst homogenen Material, das der Verformung einen ganz anderen Widerstand entgegensetzt. Da das Hülsenmaterial aber vor allem den Anforderungen der Endsinterung (Sauerstoffpermeabilität und chemische Stabilität) genügen muss, kann es nicht beliebig durch ein für den Ziehprozess optimaleres Material ersetzt werden. Aus diesen Gründen sind die Supraleitung empfindlich störende oder reduzierende Unregelmässigkeiten in den gemäss dem Stande der Technik hergestellten drahtförmigen Leitern nur durch höchste Sorgfalt vermeidbar, eine Sorgfalt, die in einem technischen Verfahren mit vertretbaren Ziehgeschwindigkeiten nicht erreichbar ist. Eine Optimierung der mechanischen Verformung durch Ziehen und der Materialeigenschaft für die anspruchsvolle Endsinterung kann durch ein und dasselbe Material nicht erreicht werden. Die grundlegende Idee liegt in der Aufgabenteilung. Zwei, für die jeweilige Aufgabe optimal gewählte Materialien sollen gemeinsam das Problem lösen und zum angestrebten Ziel führen.

In dem erfindungsgemässen Verfahren, wie in Anspruch 1 definiert, werden die oben genannten Schwierigkeiten also umgangen, indem die zu verformende, mit dem supraleitenden Material gefüllte Umhülsung in eine weitere Umhülsung gebracht wird, wodurch eine Kombination mit einer inneren und einer äusseren Umhülsung entsteht, wobei die innere Umhülsung, die Sinterhülse, die Bedingungen für die Endsinterung optimal erfüllt und die äussere Umhülsung, die Ziehhülse, einen problemlosen, gegenüber Bisherigem schnellen Ziehvorgang ermöglicht. Dazu ist die äussere Umhülsung derart ausgelegt, dass sie erstens beim Ziehen den grössten Teil der Zugkraft aufnimmt, dass sie zweitens die innere Umhülsung in keiner Weise verändert oder gefährdet und dass sie drittens nach dem Ziehen von der erzeugten Drahtform wieder entfernbar ist. Ein bspw. Vorgehen zur schonenden Entfernung der Ziehhülse von der Sinterhülse ist beispielsweise ein Ätzverfahren.

Eine derartige Ziehhülse kann beispielsweise ein weichgeglühtes Stahlrohr (St 35) sein, in welche die mit dem Keramikmaterial gefüllte Sinterhülse, ein Silberoder Silberlegierungsrohr, eingeführt wird. Die Hülsenkombination wird auf einer normalen Drahtziehmaschine einem Ziehvorgang unterzogen, wobei pro Ziehschritt wiederum eine Querschnittabnahme von ca 8% erreicht wird. Wie die silberne Sinterhülse wird auch die äussere Ziehhülse durch die Kaltverformung heim Ziehen hart und spröde. Aus diesem Grunde wird der Ziehvorgang mindestens einmal unterbrochen, die aus Stahl bestehende, nun dünnwandige Ziehhülse abgeätzt und die silberne Sinterhülse bei ca. 280° weichgeglüht. Dann wird die Sinterhülse mit dem supraleitenden Inhalt in eine neue, weichgeglühte Ziehhülse eingeführt und anschliessend weiteren Ziehschritten unterzogen. Das fertig gezogene Produkt, in welchem die den Kern umhüllende Sinterhülse den gewünschten Durchmesser (Querschnitt) aufweist, wird zur Entfernung der Ziehhülse wiederum mit Säure behandelt und darauf einer Endsinterung unter strömendem Sauerstoff unterworfen. Die Endsinterung wird in genau derselben Weise durchgeführt wie bei entsprechenden drahtförmigen Leitern, die nach der bekannten Methode gemäss der eingangs diskutierten Dissertation hergestellt wurden, das heisst mit anderen Worten, die Eigenschaften des Silbermantels werden durch die für die Entfernung des äusseren. als Zugbehelf dienenden Stahlmantels notwendigen Ätzschritte nicht beeinflusst.

Wie bereits oben erwähnt, ist das Ziehen der Hülsenkombination auf handelsüblichen Drahtziehmaschinen mit entsprechenden Ziehgeschwindigkeiten möglich. Der gemäss dem erfindungsgemässen Verfahren hergestellte drahtförmige Leiter mit einem Kern aus supraleitendem Keramikmaterial, erfüllt die an supraleitende, drahtförmige Leiter gestellten, hohen Qualitätsanforderungen bestens. Nach dem erfindungsgemässen Verfahren können auch drahtförmige Leiter mit flachem Querschnitt (Bänder) hergestellt werden, indem die fertig gezogene Hülsenkombination flach gewalzt wird, bevor die Ziehhülse durch Ätzen entfernt und das Band endgesintert wird. Auch drahtförmige Leiter mit einer Mehrzahl von supraleitenden Kernen sind herstellbar, indem von Silberhülsen ausgegangen wird, deren innerer Hohlraum nicht direkt mit Keramikmaterial gefüllt wird, sondern mit fertigen drahtförmigen Leitern mit mindestens einem supraleitenden Kern.

Die Erfindung soll nun anhand der folgenden Figuren im Detail beschrieben werden. Dabei zeigen:
- **Figur 1**: ein Längsschnitt durch einen beispielhaften Draht mit supraleitendem Kern, Sinterhülse und Ziehhülse, sowie ein Diagramm der Zugkraft während des Ziehvorganges;
- **Figur 2**: ein Schema eines beispielhaften Ummantelungsprozesses für das Einbringen des Drahtes in die Ziehhülse;
- **Figuren 3 bis 6**: Querschnitte durch Ziehhülse und Draht während des Ummantelungsprozesses gemäss Figur 2;
- **Figuren 7 und 8**: Querschnitte durch beispielhafte Ausführungsformen von doppelt umhülsten Drähten mit supraleitendem Kern nach einem Ummantelungsprozess gemäss Figuren 2 bis 6.

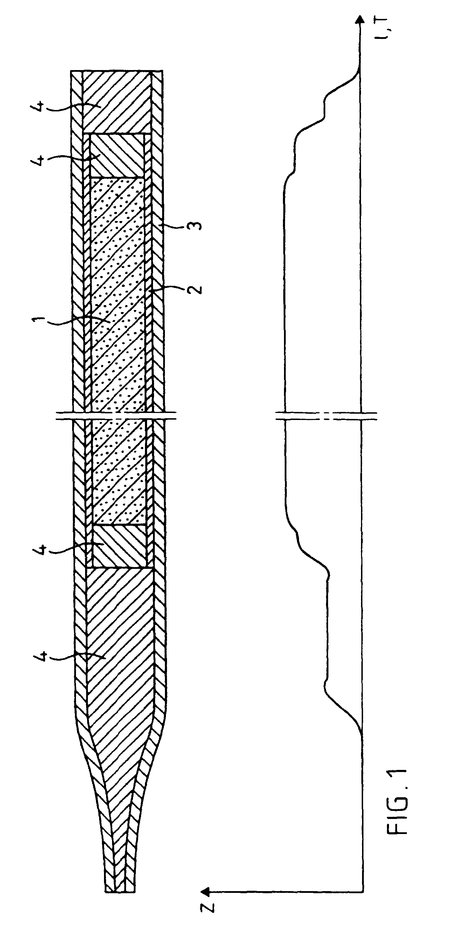

**Figur 1** zeigt schematisch eine Hülsenkombination im Schnitt, wie sie zum Ziehen von drahtförmigen Leitern mit Kern aus supraleitendem Keramikmaterial nach dem erfindungsgemässen Verfahren zur Anwendung kommt. Unter der geschnittenen Hülsenkombination ist schematisch auch noch ein Diagramm der beim Ziehen durch die Hülsenkombination aufgenommenen Zugkraft Z dargestellt, wobei die Zugkraft als Funktion der Kombinationslänge 1, das heisst der eben durch den Ziehstein laufenden Kombinationsstelle, oder der Zeit T, insbesondere der Anfangs- und Endphase des Ziehvorganges, dargestellt.

Die Hülsenkombination besteht aus einem Kern 1 aus dem supraleitenden Keramikmaterial, aus einer Sinterhülse 2 aus Silber oder einer Silberlegierung und aus einer Ziehhülse 3 aus weichgeglühtem Stahl 35 (St 35). Die Enden der Rohrkombination sind mit Bleipfropfen 4 verschlossen.

Die Zugkraft Z ist in einer ersten Phase, in der nur die Ziehhülse 3 gefüllt mit dem Bleipfropfen 4 durch den Ziehstein gezogen wird, relativ niedrig und erhöht sich, sobald auch die Silberhülse in den Ziehstein gerät. Die Zugkraft erreicht einen Höchstwert, sobald das Keramikmaterial 3 ebenfalls gezogen wird. Bemerkenswert ist, dass der Ziehprozess sehr kontinuierlich abläuft, das heisst, die Zugkraft sehr stabil auf dem Höchstwert verbleibt, solange das Hauptstück der Hülsenkombination mit Kern 1, Sinterhülse 2 und Ziehhülse 3 durch den Ziehstein gezogen wird.

Für eine beispielhafte Verfahrensvariante wird als Sinterhülse von einem Silberrohr mit einem Aussendurchmesser von 10mm und einem Innendurchmesser von 8mm ausgegangen, das mit dem supraleitenden Keramikmaterial (beispielsweise YBa₂Cu₃Oₓ oder Bi₂Sr₂CaCu₂Oₓ) gefüllt und in ein äusseres Rohr (Ziehhülse) aus weichgeglühtem Stahl 35 mit einem Aussendurchmesser von 16mm und einem Innendurchmesser von 11 mm gesteckt wird. Diese Hülsenkombination wird an ihren Enden mit Bleipfropfen verschlossen und in mehreren Ziehschritten mit einer Querschnittverminderung von jeweils ca. 8% gezogen, bis eine Hülsenkombination entsteht mit einer Ziehhülse mit den Durchmessern 6,6mm aussen bzw. 4,54mm innen und einer Sinterhülse mit den Durchmessern 4,54mm aussen bzw. 3,63mm innen. Die Ziehhülse wird abgeätzt und die Sinterhülse weichgeglüht. Die weichgeglühte Sinterhülse wird in eine zweite Ziehhülse (wiederum aus weichgeglühtem Stahl 35) mit den Durchmessern 8mm aussen bzw. 5mm innen gebracht und in weiteren Ziehschritten weiter verformt, bis die Ziehhülse Durchmesser von 1,16mm aussen bzw. 0,725mm innen, die Sinterhülse Durchmesser von 0,725mm aussen bzw. 0,58mm innen aufweisen.

Für das Einbringen der mit dem supraleitenden Material gefüllten Sinterhülse in eine Ziehhülse, insbesondere nach bereits vollzogenen Ziehschritten, wenn also die Sinterhülse bereits einen kleinen Querschnitt und eine beträchtliche Länge aufweist, kann ein kontinuierliches Verfahren zur Anwendung kommen, in dem die Ziehhülse in Form eines Ummantelungsbandes unmittelbar vor dem Ziehen um die Sinterhülse gelegt wird. Mit einem derartigen Verfahren werden dann Rolle-zu-Rolle-Verfahren möglich.

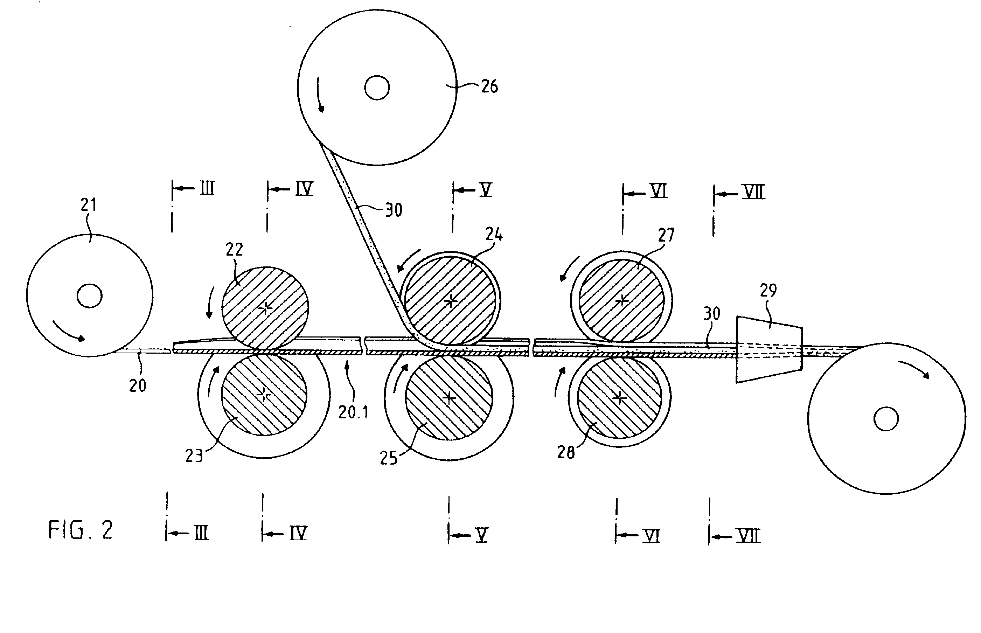

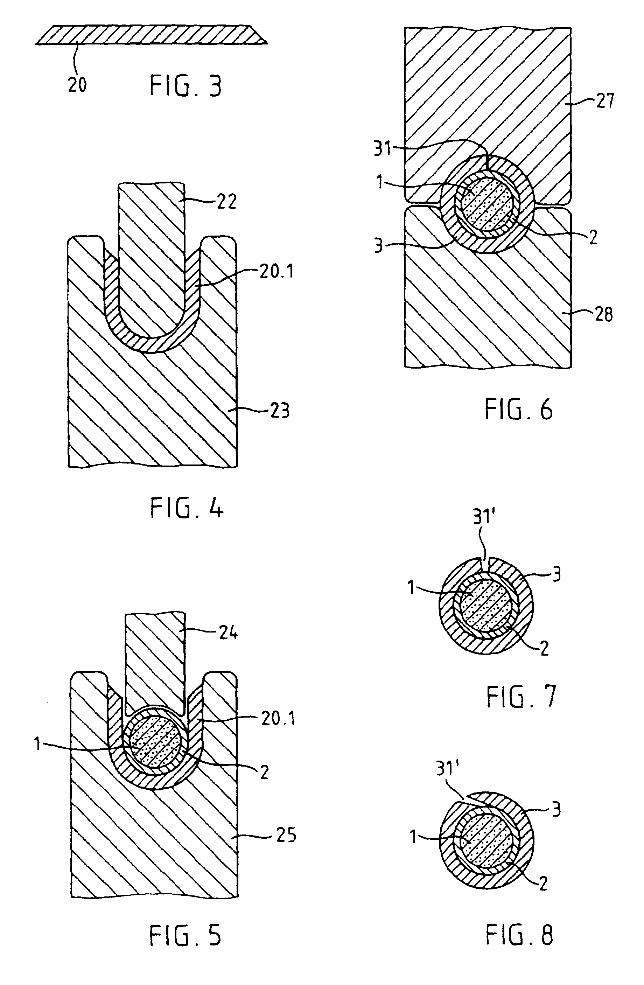

**Figur 2** zeigt schematisch ein beispielhaftes, derartiges Rolle-zu-Rolle-Verfahren. **Figuren 3 bis 7** sind Querschnitte insbesondere durch das zur Ziehhülse zu verformende Band 20 und durch den Draht 30 mit Sinterhülse und Ziehhülse entsprechend den Schnittlinien III-III IV-IV, V-V, VI-VI und VII- VII in der Figur 2.

Das Ummantelungsband 20 (Querschnitt gemäss Schnittlinie III-III: Figur 3), das beispielsweise aus Stahl 35 besteht, wird beispielsweise ab einer Vorratsrolle 21 in die Anordnung zur Ummantelung eingespeist. Zwischen einem ersten Rollenpaar 22/23 wird das Ummantelungsband 20 zu einem U-förmigen Profil 20.1 deformiert, dessen innerer Durchmesser dem Durchmesser des zu ummantelnden Drahtes 30 entspricht. Figur 4 zeigt die Profile der beiden Rollen 22 und 23 sowie das U-förmige Profil 20.1 im Querschnitt (Schnittlinie IV-IV).

In das U-förmige Profil 20.1 wird mit Hilfe eines zweiten Rollenpaares 24/25 der Draht 30 (bestehend aus dem supraleitenden Kern 1 und der Sinterhülse 2), auf dessen Durchmesser der Innendurchmesser des U-förmigen Profils 20.1 abgestimmt ist, eingelegt. Der Draht 30 wird ab einer Rolle 26 oder von einer vorgeschalteten Zieheinrichtung (nicht dargestellt) direkt zugeführt. Figur 5 zeigt das Profil der Rollen 24 und 25, sowie den in das U-förmige Profil 20.1 eingelegten Draht, der aus dem supraleitenden Kern 1 und der Sinterhülse 2 besteht.

Das U-förmige Profil 20.1 wird mit Hilfe eines dritten Rollenpaares 27/28 um den Draht 30 geschlossen und bildet nun die Ziehhülse 3. Figur 6 zeigt das Profil der Rollen 27 und 28 und einen Querschnitt durch den doppelt ummantelten Draht (1/2/3). Die Ziehhülse, die in einem kontinuierlichen Ummantelungsprozess hergestellt wird, hat im Gegensatz zu einer aus einem Rohr hergestellten Ziehhülse eine Naht 31. Diese Naht 31 kann, wie in der Figur 6 dargestellt eine radial ausgerichtete Stossnaht sein. Wird der doppelt umhüllte Draht, wie er zwischen dem Rollenpaar 27/28 geformt wird, aus der Führung dieses Rollenpaares entlassen, kann die Naht 31 durch die Elastizität des Materials der Ziehhülse 3 sich wieder leicht öffnen, wie dies im Querschnitt durch denselben Draht gemäss Figur 7 (Schnittlinie VII-VII, Figur 2) dargestellt ist, sodass in der Ziehhülse eine Fuge 31' entsteht.

Der fertig ummantelte Draht wird beispielsweise direkt durch einen Ziehstein 29 gezogen und dann aufgerollt. Beim Ziehen wird die Fuge 31' durch die dabei wirkenden radialen Kräfte wieder geschlossen.

**Figur 8** zeigt einen Querschnitt durch einen doppelt umhülsten Draht, der eine nicht radiale, sondern schiefe Naht bzw. Fuge 31' aufweist. Auch anders geformte Nähte können nach demselben Verfahren erzeugt werden. In jedem Falle müssen die Schmalseiten des Ummantelungsbandes 20 entsprechend der zu erstellenden Naht ausgebildet sein, wobei die Genauigkeit des Bandquerschnittes derart gewählt werden muss, dass durch die im Ummantelungsprozess entstehende Naht 29 weder die Zieheigenschaften des doppelt ummantelten Drahtes negativ beeinflusst werden noch dass durch die Naht die Sinterhülse 2 oder der supraleitende Kern 1 deformiert und dadurch in Mitleidenschaft gezogen werden.

Anstelle eines Ummantelungsprozesses gemäss Figur 2, das von einem Ummantelungsband 30 ausgeht, kann auch ein Verfahren zur Anwendung kommen, das direkt von einem U-förmigen Profil 20.1 ausgeht. Dieses U-förmige Profil wird vorgängig vorteilhafterweise weichgeglüht.

Anstelle von zwei Rollenpaaren 22/23 und 27/28 zur Deformation des Ummantelungsbandes 20 zur Ziehhülse 3 können auch für eine mehrstufige Deformation mehr als zwei Rollenpaare eingesetzt werden.

Die Rollenpaare 22/23,24/25 und 27/28 können angetrieben sein und nicht nur zur Deformation des Ummantelungsbandes und zur Positionierung des Drahtes im teilweise deformierten Band dienen sondern auch dazu, den Draht 30 und das Ummantelungsband 20 mit einem Minimum an Zug- und Stosskräften durch den Ummantelungsprozess zu fördern.

Wird zur Ummantelung des Drahtes bestehend aus Sinterhülse und supraleitendem Kern mit einer Ziehhülse ein Verfahren gemäss Figuren 2 bis 7 oder ein ähnliches Verfahren verwendet, bedeutet dies, dass die Ziehhülse während des Ummantelungsprozesses bereits kalt verformt wird und deshalb für das Ziehen eine gegenüber einer weichgeglühten Hülse wahrscheinlich leicht reduzierte Duktilität aufweist. Dies bedeutet im Vergleich mit einem Verfahren, in dem als Ziehhülse eine weichgeglühtes Rohr zur Anwendung kommt, dass die Ziehhülse wahrscheinlich nach weniger Ziehschritten, d.h. nach einer geringeren Querschnittsreduktion bereits wieder abgeätzt und ersetzt werden muss. Für jeden spezifischen Fall muss durch den Zieh-Fachmann ein Optimum zwischen Ziehhülsen-Material. Ummantelungsverfahren, Ziehhülsendicke und Querschnittsreduktion zwischen zwei Ummantelungsschritten eruiert werden.

## Patentansprüche

1. , Verfahren zum Ziehen von drahtförmigen Supraleitern, die in einer Sinterhülse aus Silber oder aus einer Silberlegierung, die für Sauerstoff permeabel sind, mindestens einen Kern aus einem supraleitenden Keramikmaterial aufweisen,
wobei der Querschnitt von Sinterhülse und Kern in einem Ziehvorgang mit einer Mehrzahl von Ziehschritten zum gewünschten Querschnitt verkleinert wird
und das gezogene Produkt einer Endsinterung unter strömendem Sauerstoff unterzogen wird,
**dadurch gekennzeichnet,**
**dass** zur Vermeidung von Ziehproblemen und zur Erhöhung der möglichen Ziehgeschwindigkeit die Sinterhülse mit dem supraleitenden Keramikmaterial vor dem Ziehvorgang in eine für den Ziehvorgang geeignete Ziehhülse gebracht wird, welche Ziehhülse aus einem Material besteht, das weniger weich ist und eine grössere Festigkeit hat als das Material der Sinterhülse,
und **dass** der Ziehvorgang an der aus den beiden Hülsen und dem mindestens einen Kern bestehenden Hülsenkombination durchgeführt wird,
wobei die Ziehhülse nach einer Anzahl von Ziehschritten entfernt und durch eine neue Ziehhülse ersetzt wird
und wobei vom fertig gezogenen Produkt vor der Endsinterung die Ziehhülse entfernt wird.

2. Verfahren nach Anspruch 1, **dadurch gekennzeichnet, dass** die Ziehhülsen (3) aus vor dem Ziehen weichgeglühtem Stahl 35 bestehen.

3. Verfahren nach Anspruch 2, **dadurch gekennzeichnet, dass** die Ziehhülsen (3) durch Ätzen mit Säure entfernt werden.

4. Verfahren nach Anspruch 1, **dadurch gekennzeichnet, dass** nach dem Entfernen der ersten Ziehhülse (3), die Sinterhülse (2) weichgeglüht wird

5. Verfahren nach einem der Ansprüche 1 bis 4, **dadurch gekennzeichnet, dass** pro Ziehschritt eine Querschnittsverminderung von 8% der Hülsenkombination erreicht wird.

6. Verfahren nach einem der Ansprüche 1 bis 5, **dadurch gekennzeichnet, dass** der Kern (1) aus YBa₂Cu₃Oₓ oder Bl₂Sr₂CaCu₂Oₓ besteht.

7. Verfahren nach einem der Ansprüche 1 bis 6, **dadurch gekennzeichnet, dass** die Hülsenkombination nach dem Ziehen durch Walzen zu einer Drahtform mit flachem Querschnitt verformt wird.

8. Verfahren nach einem der Ansprüche 1 bis 7, **dadurch gekennzeichnet, dass** der Kern (1) in der Sinterhülse (2) aus einer Mehrzahl von drahtförmigen Leitern mit supraleitenden Kernen besteht.

9. Verfahren nach einem der Ansprüche 1 bis 8, **dadurch gekennzeichnet, dass** die Sinterhülse (2) mit dem supraleitenden Kern (1) zur Einbringung in eine Ziehhülse (3) in einem kontinuierlichen Ummantelungsprozess mit einem Ummantalungsband (20) ummantelt wird.

10. Verfahren nach Anspruch 9, **dadurch gekennzeichnet, dass** in dem kontinuierlichen Ummantelungsprozess das Ummantelungsband (20) zu einem U-förmigen Profil (20.1) deformiert wird, dass ein Draht bestehend aus supraleitendem Kern (1) und Sinterhülse (2) in das U-förmige Profil (20.1) eingelegt wird und dass dann das U-förmige Profil (20.1) durch weitere Deformation zu einer geschlossenen Zehhülse (3) geformt wird.

## Claims

1. Process for drawing filamentary superconductors having within a sintering sleeve (2) of silver or of a silver alloy being permeable to oxygen at least one core of a superconducting ceramic material, wherein the cross-section of sintering sleeve and core is reduced to the desired cross-section in a drawing process comprising a plurality of drawing steps and wherein the drawn product is subjected to a final sintering under flowing oxygen, **characterized in that** for avoiding drawing problems and for increasing the possible drawing speed, the sintering sleeve (2) with the superconducting ceramic material is brought, prior to drawing, into a drawing sleeve (3) suitable for the drawing process and made of a material being less soft and having a greater strength the material of the sintering sleeve, **in that** the drawing process is performed on the sleeve combination comprising the two sleeves (2 and 3) and the at least one core (1), wherein after a number of drawing steps the drawing sleeve is removed and replaced by a new drawing sleeve and wherein the drawing sleeve is removed from the finally drawn product before the final sintering.

2. Process according to claim 1, **characterized in that** the drawing sleeves (3) are made from steel (35) soft annealed prior to drawing.

3. Process according to claim 2, **characterized in that** the drawing sleeves (3) are removed by etching with acid.

4. Process according to claim 1, **characterized in that** the sintering sleeve (2) is soft annealed after removing the first drawing sleeve (3).

5. Process according to one of claims 1 to 4, **characterized in that** for each drawing step there is a cross sectional reduction of 8% on the part of the sleeve combination.

6. Process according to one of claims 1 to 5, **characterized in that** the core is made from YBa₂Cu₃Oₓ or from Bi₂Sr₂CaCu₂Oₓ.

7. Process according to one of claims 1 to 6, **characterized in that** the sleeve combination, after drawing , is formed by rolling into a filametary shape with a flat cross-section.

8. Process according to one of claims 1 to 7, **characterized in that** the core (1) in the sintering sleeve (2) comprises a plurality of filamentary conductors with superconducting cores.

9. Process according to one of claims 1 to 8, **characterized in that** the sintering sleeve (2) with the superconducting core (1) is enveloped in a continuous enveloping process with an enveloping strip (29) for introduction into a drawing sleeve (3).

10. Process according to claim 9, **characterized in that** in the continuous enveloping process the enveloping strip (20) is deformed to give a U-shaped profile (20.1), that a filament comprising the superconducting core (1) and sintering sleeve (2) is placed in the U-shaped profile (20.1) and then the U-shaped profile (20.1) is shaped by further deformation to a closed drawing sleeve (3).

## Revendications

1. Procédée pour l'étirage de supraconducteurs filiformes qui présentent, à l'intérieure d'une gaine frittée (2) constituée en argent ou en un alliage d'argent perméable à l'oxygène, au moins un noyau constitué en un matériau céramique supraconducteur, la section transversale de la gaine frittée et du noyau étant réduite, au cours d'une pluralité d'étapes d'étirage, jusqu'à sa dimension souhaitée, et le produit étiré étant suomis à un frittage terminal sous un courant d'oxygène, **caractérisé en ce que** pour éviter des problèmes de traction et pour élever la vitesse possible de cet étirage, la gaine frittée (2) est introduite, avec le matériau céramique supraconducteur, avant l'étirage dans une gaine d' étirage (3), appropriée à l'opération d'étirage et constituée en un matériau, qui est moins mou et plus résistant que le matériau de la gaine frittée, et **en ce que** l'opération d'étirage est exécutée sur la combinaison constituée des deux gaines (2 et 3) et d'au moins un noyau (1), la gaine d'étirage étant enlevée et remplacée avec une nouvelle gaine d'étirage après un nombre d'étapes d'étirage et la gaine d'étirage étant enlevée du produit final avant le frittage terminal.

2. Procédé selon la revendication 1, **caractérisé en ce que** la gaine d'étirage (3) est constituée en un acier 35 ayant subi un recuit avant l'étirage.

3. Procédé selon la revendication 2, **caractérisé en ce que** les gaines d'étirage (3) sont éliminées par décapage ou au moyen d'un acide.

4. Procédé selon la revendication 1, **caractérisé en ce qu'**après l'élimination de la première gaine d'étirage (3) la gaine frittée subit un recuit.

5. Procédé selon l'une des revendications 1 à 4, **caractérisé en ce qu'**à chaque opération d'étirage on obtient pour la combinaison des gaines une réduction de 8% de sa section transversale.

6. Procédé selon l'une des revendications 1 à 5, **caractérisé en ce que** le noyau (1) est constitué en YBa₂Cu₃Oₓ ou en Bi₂Sr₂CaCu₂Oₓ.

7. Procédé selon l'une des revendications 1 à 6, **caractérisé en ce qu'**après l'étirage, la combinaison de gaines subit une déformation par taminage pour obtenir un câble en forme de ruban à section transversale aplatie.

8. Procédé selon l'une des revendications 1 à 7, **caractérisé en ce que** le noyau (1) placé à l'intérieur de la gaine frittée (2) est constitué d'une pluralité de conducteurs filiformes avec des noyaux supraconducteurs.

9. Procédé selon l'une des revendications 1 à 8, **caractérisé en ce que** la gaine frittée (2) contenant le noyau supraconducteur (1) est, en vue de son introduction dans une gaine d'étirage (3), gainée à l'aide d'un ruban de gainage (20) qui est appliqué au cours d'un processus de guipage continu.

10. Procédé selon la revendication 9, **caractérisé en ce que** pendant le processus de guipage continu le ruban de gainage (20) est déformé pour présenter un profil en forme de U (20.1), **en ce qu'**un câble constitué d'un noyau supraconducteur (1) et d'une gaine frittée (2) est introduit dans le profil (20.1) en forme de U, et **en ce qu'**ensuite ce profile (20.1) en forme de U subit une déformation ultérieure pour constituer une gaine d'étirage fermée (3).
